(19) Europäisches Patentamt
European Patent Office
Office européen des brevets

(11) EP 4 455 743 A1

(12) EUROPEAN PATENT APPLICATION
published in accordance with Art. 153(4) EPC

(43) Date of publication:
30.10.2024 Bulletin 2024/44

(51) International Patent Classification (IPC):
$G02B\ 3/00^{(2006.01)}$    $G02B\ 5/02^{(2006.01)}$
$H01L\ 31/0232^{(2014.01)}$    $H01L\ 31/12^{(2006.01)}$
$H01S\ 5/02253^{(2021.01)}$

(21) Application number: 22911289.1

(22) Date of filing: 21.12.2022

(52) Cooperative Patent Classification (CPC):
G02B 3/00; G02B 5/02; H01L 31/0232;
H01L 31/12; H01S 5/02253

(86) International application number:
PCT/JP2022/047153

(87) International publication number:
WO 2023/120587 (29.06.2023 Gazette 2023/26)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 24.12.2021 JP 2021211351

(71) Applicant: Kyocera Corporation
Kyoto-shi, Kyoto 612-8501 (JP)

(72) Inventors:
• YAMASAKI Sho
Kyoto-shi, Kyoto 612-8501 (JP)
• HONDA Megumi
Kyoto-shi, Kyoto 612-8501 (JP)

(74) Representative: Viering, Jentschura & Partner
mbB
Patent- und Rechtsanwälte
Am Brauhaus 8
01099 Dresden (DE)

(54) **MICROLENS ARRAY, LIGHT-EMITTING DEVICE, AND SENSOR MODULE**

(57)    A microlens array includes: multiple first lenses having vertex heights higher than or equal to a first vertex height; and a second lens having a vertex height lower than the first vertex height. The microlens array includes: a first region in which a vertex distance between two first lenses, of the multiple first lenses, aligned in a first direction is smaller than a threshold in plan view; and a second region in which a vertex distance between two first lenses, of the multiple first lenses, aligned in the first direction is larger than the threshold in plan view, and the second lens is located between the two first lenses in the second region.

FIG. 1A

EP 4 455 743 A1

## Description

TECHNICAL FIELD

The present disclosure relates to a microlens array, a light-emitting device, and a sensor module.

BACKGROUND OF INVENTION

Japanese Unexamined Patent Application Publication No. 2003-4907 discloses a microlens array including multiple lenses located such that the vertex distances of the lenses are located in an irregular manner.

SUMMARY

SOLUTION TO PROBLEM

In the present disclosure, a microlens array includes:

multiple first lenses having vertex heights higher than or equal to a first vertex height; and
a second lens having a vertex height lower than the first vertex height,
the microlens array includes:

a first region in which a vertex distance between two first lenses, of the multiple first lenses, aligned in a first direction is smaller than a threshold in plan view; and
a second region in which a vertex distance between two first lenses, of the multiple first lenses, aligned in the first direction is larger than the threshold in plan view, and
the second lens is located between the two first lenses in the second region.

In the present disclosure, a light-emitting device includes:

a light-emitting element; and
the microlens array mentioned above, located in a path of light emitted by the light-emitting element.

In the present disclosure, a sensor module includes:

the light-emitting device mentioned above; and
a light-reception device configured to receive light emitted by the light-emitting device.

BRIEF DESCRIPTION OF THE DRAWINGS

FIG. 1A is a vertical cross-sectional view of a microlens array according to an embodiment of the present invention.
FIG. 1B is a plan view of the microlens array according to the embodiment of the present invention.
FIG. 2 is a diagram for explaining a region where a second lens is located in the microlens array of Embodiment 1.
FIG. 3 is a diagram for explaining the vertex heights of second lenses of a microlens array of Embodiment 2.
FIG. 4 is a plan view of a microlens array in which first lenses are imaginarily arranged in a regular manner without changing the average value of vertex densities.
FIG. 5 is a diagram for explaining the vertex heights of second lenses of a microlens array of Embodiment 3.
FIG. 6 is a diagram for explaining the vertex heights of second lenses of a microlens array of Embodiment 4.
FIG. 7 is a diagram for explaining the vertex heights of second lenses of a microlens array of Embodiment 5.
FIG. 8 is a diagram for explaining a second lens in a microlens array of Embodiment 6.
FIG. 9 is a diagram illustrating the light distribution characteristics of a first lens and a second lens in Embodiment 6.
FIG. 10 is a diagram for explaining a lens arrangement in the directions parallel to the plane of a microlens array of Embodiment 7.
FIG. 11 is a diagram for explaining a lens arrangement in the directions parallel to the plane of a microlens array of Embodiment 8.
FIG. 12 is a diagram for explaining an example of a method of manufacturing a microlens array of an embodiment.
FIG. 13 is a diagram illustrating a light-emitting device and a sensor module according to an embodiment of the present disclosure.

DESCRIPTION OF EMBODIMENTS

Hereinafter, embodiments of the present disclosure will be described in detail with reference to the drawings.

(Embodiment 1)

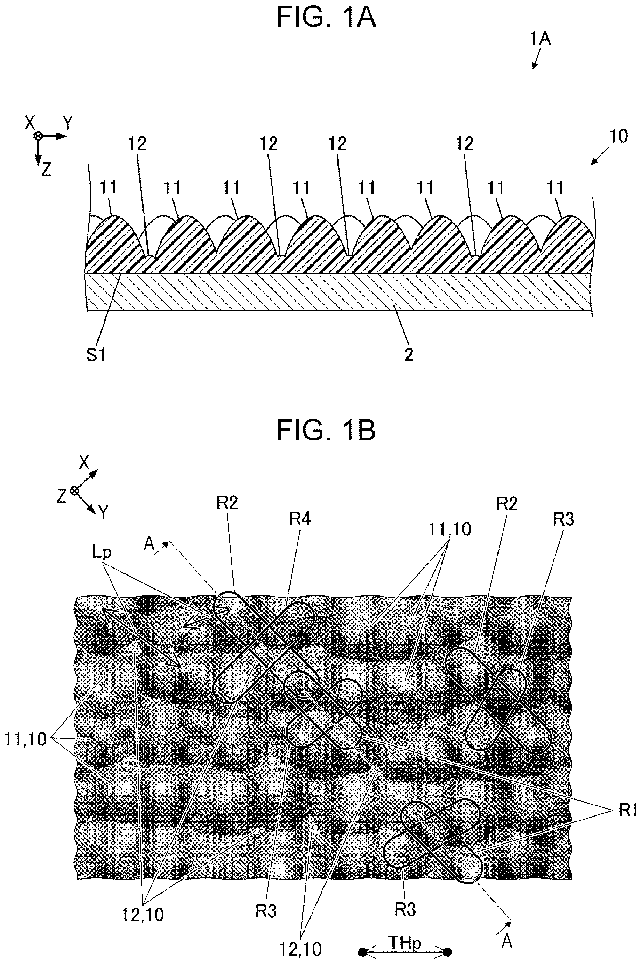

FIG. 1A is a vertical cross-sectional view of a microlens array according to an embodiment of the present invention. FIG. 1B is a plan view of the microlens array. FIG. 1A illustrates a cross section taken along line A-A in FIG. 1B.
As illustrated in FIGs. 1A and 1B, the microlens array 1A of Embodiment 1 includes multiple lenses 10. Each lens 10 may be a convex lens including a vertex on its one side. The multiple lenses 10 may be arranged parallel with a plane S1 (a flat plane in FIG. 1A) in two-dimensional directions, and each lens 10 may have the optical axis (in other words, the main axis) in the direction normal to the plane S1. The multiple lenses 10 may be connected with one another on the plane S1 side. The multiple lenses 10 may have a unitary structure, which is integrally molded. The microlens array 1A may include a transparent substrate 2 such as a glass substrate so that the multiple lenses 10 are located on the transparent substrate 2.

In this configuration, if light enters the microlens array 1A from its one side (specifically, the side on which the vertices of the lenses 10 are located in the Z direction), the light is refracted by the multiple lenses 10, and diffused light can be emitted from the other face of the microlens array 1A.

<Details of Multiple Lenses>

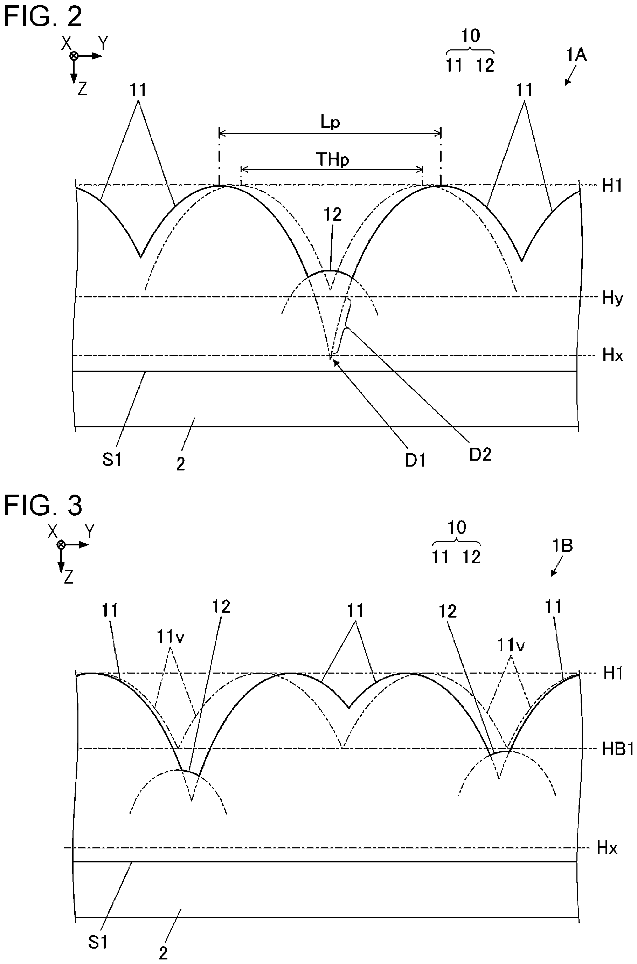

FIG. 2 is a diagram for explaining a region where a second lens is located in the microlens array of Embodiment 1.

In the following, the height from a certain reference plane to the vertex of a lens is referred to as "vertex height". The reference plane may be any plane parallel to the plane S1 on which the multiple lenses 10 are arrayed. As for each lens 10, a range in which a lens's curved surface (for example, a convex curved surface) continues is regarded as one lens 10. In other words, a peripheral edge at which a lens curved surface has a sharp change, for example, a valley at which a lens curved surface intersects another adjacent lens 10, denotes a boundary of one lens 10. In another case, a bend portion at which a lens curved surface intersects a surface other than a lens curved surface (for example, a flat surface or the like) denotes a boundary of one lens 10. The bend portion mentioned above does not refer to a bend portion in a strict sense and is a concept including a bend portion including small roundness. The length in the optical axis direction from the lowermost end of the boundaries of one lens 10 to the uppermost end of the lens 10 (which, for example, if the lens 10 has a vertex, refers to the vertex) is referred to as "the vertical dimension of the lens".

The multiple lenses 10 may include multiple first lenses 11 having vertex heights higher than or equal to a first vertex height H1 (see FIG. 2) and one or more second lenses 12 having vertex heights lower than the first vertex height H1 (see FIGs. 1A and 1B).

The first lenses 11 and the second lenses 12 may have distinct differences in vertex heights. Specifically, the maximum value of the vertical dimensions of the one or more second lenses 12 may be smaller than or equal to the minimum value of the vertical dimensions of the multiple first lenses 11. The multiple first lenses 11 may have variations in vertex heights.

The multiple first lenses 11 may have the first vertex height H1 as illustrated in FIG. 2. Specifically, the vertex heights of the first lenses 11 may be in agreement with the first vertex height H1. The word "agreement" denotes not only "agreement in a strict sense" but is a concept including cases in which the variations are within a specified error. The range of the error in this context may be a range from the first vertex height H1 to (the first vertex height H1 + 15% of the reference vertical dimension (described later) of the first lenses 11). This configuration enables first lenses 11 having the same or similar vertex heights to be located in multiple regions of the microlens array 1A and hence enables the multiple regions to have the same or similar light distribution characteristics by the first lenses 11.

The multiple first lenses 11 may have the same size and the same lens shape. This configuration makes it more likely for the multiple regions of the microlens array 1A to have the same or similar light distribution characteristics. The words "the same size and the same lens shape" denote not only "agreement in a strict sense" but is a concept including cases in which the variations are within a specified error. The error denotes that the maximum difference in the sag of each point is within 15% of the reference vertical dimension (described later) of the first lenses 11 as compared with that of the curved surface of one lens. Even if the boundary positions of lens curved surfaces are different, if the shapes in the boundaries are the same, the shapes of the curved surfaces can be regarded as being the same.

As illustrated in FIG. 1B, as for the vertex distance Lp of two first lenses 11 aligned in a first direction (for example, the Y direction) in plan view, the microlens array 1A may include a first region R1 in which the vertex distance Lp is smaller than a threshold THp and a second region R2 in which the vertex distance Lp is larger than the threshold THp. This configuration causes variations in the vertex distances of the first lenses 11. Hence, this configuration reduces the effect that light beams having passed through the multiple first lenses 11 are overlayed regularly and cause interference fringes, and provides favorable light distribution characteristics. The words "plan view" denote viewing in the direction orthogonal to the plane S1.

As illustrated in FIG. 1B, as for the vertex distance of two first lenses 11 aligned in a second direction (for example, the X direction) different from the first direction in plan view, the microlens array 1A may include a third region R3 in which the vertex distance is smaller than the threshold THp and a fourth region R4 in which the vertex distance is larger than the threshold THp. Also this configuration causes variations in the vertex distances of the first lenses 11. Hence, this configuration reduces the effect that light beams having passed through the multiple first lenses 11 are overlayed regularly and cause interference fringes, and provides favorable light distribution characteristics.

A second lens 12 may be located between two first lenses 11 in a second region R2 in which the vertex distance is larger than the threshold THp. A second lens 12 may be located between multiple first lenses 11 in a region where the second region R2 and fourth region R4 in which the vertex distance is larger than the threshold THp overlap each other.

As illustrated in FIG. 2, the threshold THp mentioned above may be set to be smaller than or equal to a vertex distance corresponding to a depth Hx, which is the depth of the valley between two adjacent first lenses 11, and at which a molding difficult portion D1 of lens curved surfaces appears. The vertex distance corresponding to the depth Hx refers to the distance of vertices the valley between which reaches the depth Hx. This setting provides favorable light distribution characteristics. This is because if a second lens 12 is not present in the second region R2, the fourth region R4, or the like where the distance between adjacent first lenses 11 is large, the valley there is deep. Hence, molding lens curved surfaces is difficult in many valleys. In contrast, if a second lens 12 is present between multiple first lenses 11 in the second region R2 or the fourth region R4, it reduces deep valleys where molding lens curved surfaces is difficult. This makes it easier to form required lens curved surfaces and makes it possible to provide the microlens array 1A with favorable light distribution characteristics.

Alternatively, as illustrated in FIG. 2, the threshold THp mentioned above may be set to be smaller than or equal to a vertex distance corresponding to a depth Hy, which is the depth of the valley between two adjacent first lenses 11, and at which a bottom portion D2 which is out of the requirement for the first lens 11 appears. The vertex distance corresponding to the depth Hy refers to the distance of vertices the valley between which reaches the depth Hy. The lens shape of the first lens 11 is designed so as to provide required light distribution characteristics. However, this lens shape corresponds to the lens shape having a width smaller than or equal to a specified width of the first lens 11. If light passes through the bottom portion D2 out of the specified width, there is a possibility that the light can deviate from the required light distribution characteristics. Hence, the above setting reduces first lenses 11 including the bottom portion D2 and makes it possible to provide favorable light distribution characteristics.

The configuration described above also provides an advantage that makes it easier to achieve light distribution characteristics having a wide diffusion angle. If second lenses 12 are not present, it limits the aspect ratio (specifically, the vertical dimension/the horizontal dimension) of the first lens 11 to reduce deep valleys where molding lens curved surfaces is difficult. However, the presence of second lenses 12 mitigates the limitation to the aspect ratio of the first lens 11, making it possible to increase the aspect ratio of the first lens 11. This makes it easier to achieve light distribution characteristics having a wide diffusion angle.

As described earlier, the second lenses 12 may have vertex heights lower than the vertex heights of the first lenses 11. This configuration makes the ratio of the area where the second lenses 12 occupy in the microlens array 1A smaller than the ratio of the area where the first lenses 11 occupy in the microlens array 1A. Accordingly, in the light diffusion effect of the microlens array 1A, the ratio of the light diffusion effect caused by the second lenses 12 is smaller than the ratio of the light diffusion effect caused by the multiple first lenses 11. This reduces deviations of the light distribution characteristics of the microlens array 1A from the required characteristics, caused by the second lenses 12.

A second lens 12 may be located such that its vertex appears between multiple first lenses 11 or such that a lens curved surface not including its vertex appears between multiple first lenses 11.

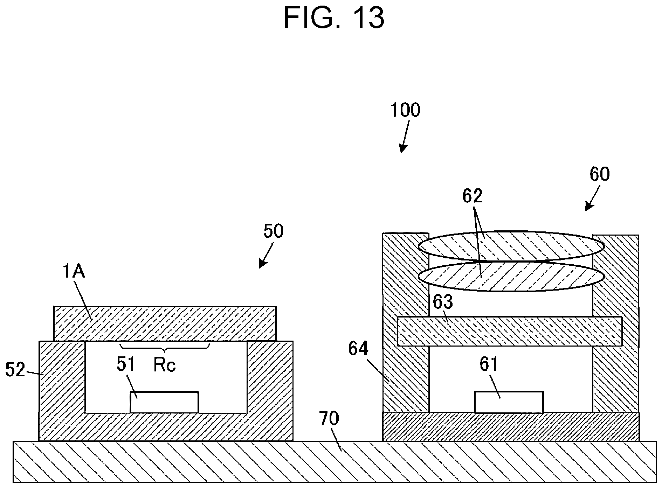

If a pass-through region Rc (see FIG. 13) is set in the microlens array 1A, all of the outer periphery of each lens 10 may be in contact with another adjacent lens 10 in at least the pass-through region Rc. The pass-through region Rc may be specified in, for example, a specification or the like as a region that light passes through. In this configuration, since surfaces (for example, flat surfaces) other than lens curved surfaces are not present in the boundaries between the lenses 10 in the pass-through region Rc, more favorable light distribution characteristics can be achieved.

Note that in the microlens array 1A of Embodiment 1, the multiple lenses 10 may include a third lens (for example, a convex lens) different from the first lenses 11 and the second lenses 12. A second lens 12 need not be located all of the second and fourth regions R2 and R4 in which the vertex distance is large. In the second and fourth regions R2 and R4 in which the vertex distance is large, the higher the rate of a second lens 12 being present, the higher the effect of second lenses 12.

(Embodiment 2)

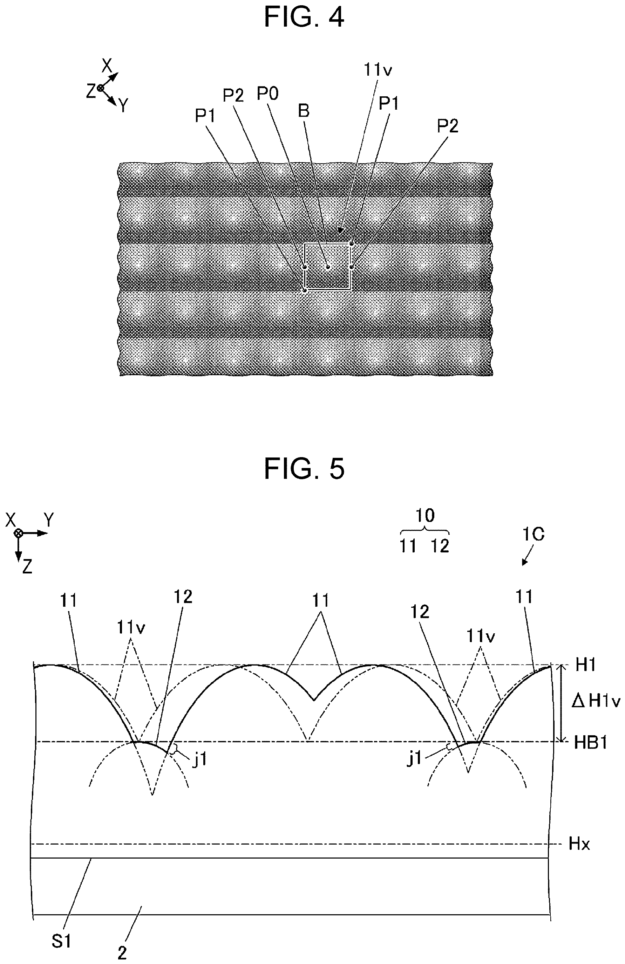

FIG. 3 is a diagram for explaining the vertex heights of second lenses of a microlens array of Embodiment 2. In the microlens array 1B of Embodiment 2, the vertex heights of the second lenses 12 differ from those in Embodiment 1, and other constituents are the same as or similar to those in Embodiment 1. Detailed description of the same or similar constituents is omitted. FIG. 4 is a plan view of a microlens array in which first lenses are imaginarily arranged in a regular manner without changing the average value of vertex densities.

A description will be given of a case in which the multiple first lenses 11 (see FIG. 1B) are imaginarily arranged in a regular manner without changing the average value of vertex densities. FIGs. 3 and 4 illustrate first lenses 11 before regular arrangement and first lenses 11v after regular arrangement with different symbols. A regular arrangement denotes that the vertices of multiple first lenses 11 are arranged in a regular manner in plan view. In a regular arrangement, the vertex heights of the multiple first lenses 11 may be the same. A regular arrangement denotes an arrangement in which the multiple first lenses 11are arranged in a lattice shape as illustrated in FIG. 4. Alternatively, a regular arrangement may be an arrangement in which the first lenses 11 are arranged in a hexagonal lattice shape. An arrangement in a hexagonal lattice shape denotes an arrangement in which multiple regular hexagons are laid out without a gap in between (in other words, an arrangement in which each side of a regular hexagon is a boundary of a pair of adjacent first lenses 11). The curved surface of the lens surface of each of the multiple first lenses 11v in a regular arrangement is continuous up to a boundary line B (see FIG. 4) with the adjacent first lenses 11v. Before regular arrangement (see FIG. 1B), the boundaries between the multiple first lenses 11 have variations in height such as high positions and low positions, and the lengths of bottoms are different. Hence, if the first lenses 11 are imaginarily arranged in a regular manner, parts of the bottoms of first lenses 11 that are exposed to the outside before regular arrangement are hidden in some cases, and parts of the bottoms of first lenses 11 that are not exposed to the outside before regular arrangement are exposed to the outside in the other cases. As for parts of bottoms newly exposed, the parts of the bottoms need only to be reconfigured such that these lenses have the same or similar shapes as other first lenses 11 large ranges of which were exposed to the outside also before regular arrangement. In FIG. 4, a vertex P0, a boundary line B, the highest point P1 in the boundary line B, and the lowest point P2 in the boundary line B are indicated only for one first lens 11v out of the multiple first lenses 11v imaginarily arranged in a regular manner. In FIG. 3, the first lenses 11v depicted with dashed double-dotted lines show an example of those imaginarily arranged in a regular manner.

As illustrated in FIG. 3, the second lenses 12 in Embodiment 2 may have vertex heights lower than or equal to a first boundary height HB1. The first boundary height HB1 denotes the height of the lowest point P1 (see FIG. 4) in the boundary of a pair of adjacent first lenses 11 if the multiple first lenses 11 are imaginarily arranged in a regular manner without changing the average value of vertex densities.

In plan view of the microlens array 1B, this configuration makes the ratio of the area of the one or more second lenses 12 much lower than the ratio of the area of the multiple first lenses 11. Accordingly, in the light diffusion effect of the microlens array 1A, the ratio of the diffusion effect caused by the second lenses 12 is much smaller than the ratio of the light diffusion effect caused by the multiple first lenses 11. This reduces deviations of the light distribution characteristics of the microlens array 1B from the required characteristics, caused by the second lenses 12.

The vertex heights of the multiple second lenses 12 need not be the same. The vertex heights of the second lenses 12 may be lower than the first boundary height HB1 and higher than the height Hx from which molding lens curved surfaces is difficult.

(Embodiment 3)

FIG. 5 is a diagram for explaining the vertex heights of second lenses of a microlens array of Embodiment 3. In the microlens array 1C of Embodiment 3, the vertex heights of the second lenses 12 differ from those in Embodiment 1, and other constituents are the same as or similar to those in Embodiment 1. Detailed description of the same or similar constituents is omitted.

The vertex height H2 of each second lens 12 according to Embodiment 3 satisfies the following condition.

$$HB1 - \Delta H1v \times 50\% \leq H2 \leq HB1$$

Here, HB1 represents the first boundary height explained in Embodiment 2. The symbol $\Delta H1v$ represents "the reference vertical dimension" of the first lenses 11 which denotes the vertical dimension of the first lenses 11v if the multiple first lenses 11 are imaginarily arranged in a regular manner without changing the average value of vertex densities.

This configuration provides the following advantageous effect in addition to the same or similar one in Embodiment 2. Specifically, the vertical dimensions of first lenses 11 adjacent to a second lens 12 are close to the vertical dimension $\Delta H1v$ of the imaginary first lenses 11v. Hence, the ratio of the bottom lens surfaces j 1 (in other words, lens surfaces j 1 with steep slopes), which are not included in the imaginary first lenses 11v, can be low. The lens curved surfaces of imaginary first lenses 11v are designed in some cases to provide required light distribution characteristics, and hence there is a possibility that the lens surfaces j 1 with steep slopes located on the bottom side relative to the imaginary first lenses 11v can cause light distribution characteristics to deviate from the required characteristics. To address such a case, the ratio of the lens surfaces j 1 mentioned above is low in the microlens array 1C of Embodiment 3, and thus the microlens array 1C of Embodiment 3 provides favorable light distribution characteristics.

(Embodiment 4)

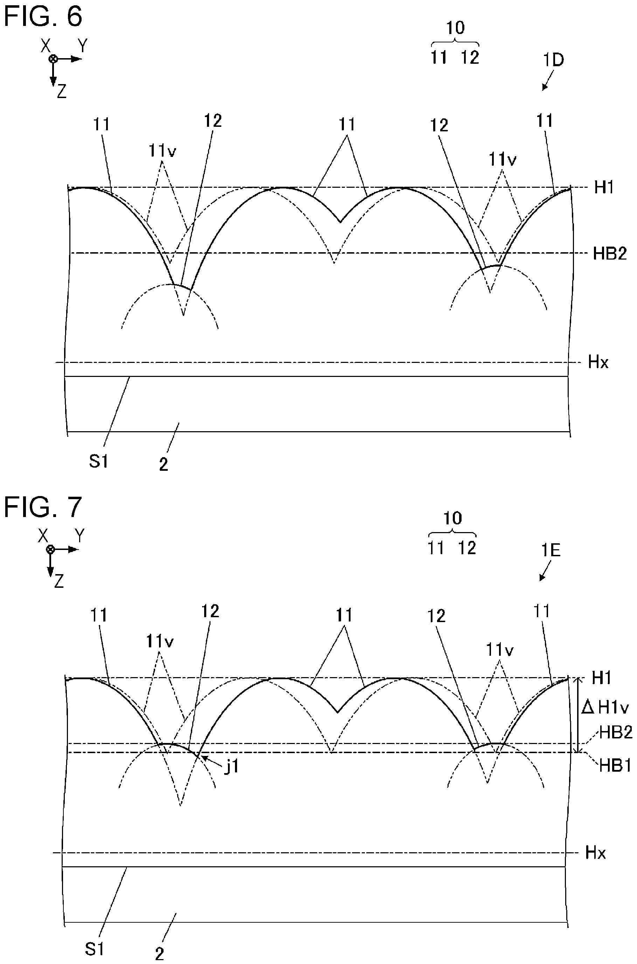

FIG. 6 is a diagram for explaining the vertex heights of second lenses of a microlens array of Embodiment 4. In the microlens array 1D of Embodiment 4, the vertex heights of the second lenses 12 differ from those in Embodiment 1, and other constituents are the same as or similar to those in Embodiment 1. Detailed description of the same or similar constituents is omitted.

In Embodiment 4, the second lenses 12 may have vertex heights lower than or equal to a second boundary height HB2. The second boundary height HB2 denotes the height of the highest point P2 in the boundary of a pair of adjacent first lenses 11v if the multiple first lenses 11 are imaginarily arranged in a regular manner without changing the average value of vertex densities.

In plan view of the microlens array 1D, this configuration makes the ratio of the area of the one or more second lenses 12 much lower than the ratio of the area of the multiple first lenses 11. Accordingly, in the light diffusion effect of the microlens array 1A, the ratio of the diffusion effect caused by the second lenses 12 is much lower the ratio of the diffusion effect caused by the multiple first lenses 11. This reduces deviations of the light distribution characteristics of the microlens array 1D from the required characteristics, caused by the second lenses 12.

The vertex heights of the multiple second lenses 12 need not be the same. The vertex heights of the second lenses 12 may be lower than the second boundary height HB2 and higher than the height Hx from which molding lens curved surfaces is difficult.

(Embodiment 5)

FIG. 7 is a diagram for explaining the vertex heights of second lenses of a microlens array of Embodiment 5. In the microlens array 1E of Embodiment 5, the vertex heights of the second lenses 12 differ from those in Embodiment 1, and other constituents are the same as or similar to those in Embodiment 1. Detailed description of the same or similar constituents is omitted.

The vertex height H2 of each second lens 12 according to Embodiment 5 satisfies the following condition.

$$HB2 - \Delta H1v \times 50\% \leq H2 \leq HB2$$

Here, HB2 is the second boundary height HB2 explained in Embodiment 4. The symbol $\Delta H1v$ represents "the reference vertical dimension" of the first lenses 11 explained in Embodiment 3.

This configuration provides the following advantageous effect in addition to the same or similar one in Embodiment 4. Specifically, the vertical dimensions of first lenses 11 adjacent to a second lens 12 are close to the vertical dimension $\Delta H1v$ of the imaginary first lenses 11v. Hence, the ratio of the bottom lens surfaces j 1 (in other words, lens surfaces j 1 with steep slopes), which are not included in the imaginary first lenses 11v, can be low. The lens curved surfaces of imaginary first lenses 11v are designed in some cases to provide required light distribution characteristics, and hence there is a possibility that the lens surfaces j 1 with steep slopes located on the bottom side relative to the imaginary first lenses 11v can cause light distribution characteristics to deviate from the required characteristics. To address such a case, the ratio of the lens surfaces j 1 mentioned above is low in the microlens array 1E of Embodiment 5, and thus the microlens array 1E of Embodiment 5 provides favorable light distribution characteristics.

(Embodiment 6)

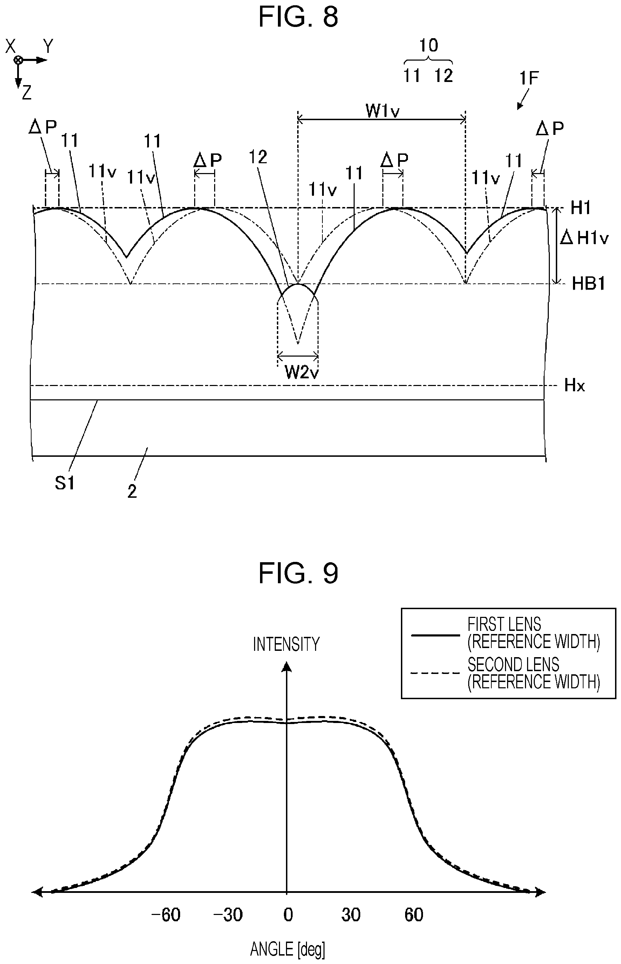

FIG. 8 is a diagram for explaining the second lenses of a microlens array of Embodiment 6. FIG. 9 is a diagram illustrating the light distribution characteristics of the first lens and the second lens in Embodiment 6. In the microlens array 1F of Embodiment 6, the lens shape and size of the second lens 12 differ from those in Embodiment 3 or Embodiment 5, and the other constituents are the same as or similar to those of Embodiment 3 or Embodiment 5. Detailed description of the same or similar constituents is omitted.

The second lenses 12 have vertex heights explained in Embodiment 3 or Embodiment 5.

The lens shapes of the second lenses 12 of Embodiment 6 may be similar to the lens shapes of the first lenses 11. With this configuration, the light distribution characteristics of the light having passed through the second lens 12 are close to the light distribution characteristics of the light having passed through the first lens 11. Hence, the required light distribution characteristics are achieved by the multiple first lenses 11, and in addition, the light having passed through the second lenses 12 also has characteristics close to the required light distribution characteristics mentioned above. Thus, this configuration provides favorable light distribution characteristics.

A reference width W2v of the second lens 12 may be twice the average value of the positional deviations $\Delta P$ of the vertex positions of the first lenses 11, with a tolerance of $\pm 30\%$.

The reference width W2v of the second lens 12 denotes the length of the portion of a second lens 12 having a shape similar to that of the first lens 11, corresponding to a reference width W1v of the first lens 11. Specifically, the reference width W2v of the second lens 12 corresponds to (the reference width W1v of the first lens 11) $\times$ (the similarity ratio of the second lens 12 to the first lens 11).

The reference width W1v of the first lens 11 denotes, if the multiple first lenses 11v are imaginarily arranged in a regular manner without changing the average value of vertex densities, the largest width of the boundary line B (see FIG. 4) of one first lens 11v in a regular arrangement.

The positional deviation $\Delta P$ of the vertex position of the first lens 11 denotes the distance between the vertex position of the first lens 11v after the regular arrangement mentioned above and the vertex position of the first lens 11 before the regular arrangement. It is assumed here that the positional deviations $\Delta P$ mentioned above are totalized in the state in which the multiple first lenses 11v after the regular arrangement are overlaid on the multiple first lenses 11 before the regular arrangement such that the total amount of the positional deviations $\Delta P$ is smallest. Although in FIG. 8, the positional deviation $\Delta P$ is indicated as if it were a displacement in the Y direction, the positional deviation $\Delta P$ denotes the

distance between two points in the X-Y plane including a displacement in the X direction.

The average value of the positional deviations ΔP may denote the average value across all of the first lenses 11 included in the microlens array 1F, or if a pass-through region Rc (see FIG. 13) is defined, the average value of the positional deviations ΔP may denote the average value across all of the first lenses 11 included in the pass-through region Rc. A ± B% denotes a range of A × (100 - B)% to A × (100 + B)%.

The configuration described above provides the following advantageous effect. If the multiple first lenses 11 are arranged so as to have positional variations with respect to those in a regular arrangement in order to reduce interference fringes, the distance between the vertices of two adjacent first lenses 11 is also varied. If the first lenses 11 have the variations mentioned above, the value of a positional deviation of the vertex position of a first lens 11 that occurs frequently is close to the average value of the positional deviations. Hence, the value of a vertex distance that occurs frequently in a region where the vertex distance of two adjacent first lenses 11 becomes larger than in the regular arrangement is close to the value twice the average value of the positional deviations.

If a second lens 12 is located between two first lenses 11 having a vertex distance twice the average value of the positional deviations, and the reference width W2v of the second lens 12 is close to twice the average value of the positional deviations mentioned above, the vertex of the second lens 12 is exposed to the outside from the height close to the reference width W2v as illustrated in FIG. 8. In other words, if the reference width W2v of the second lens 12 is the length mentioned above, the vertices of many second lenses 12 are exposed to the outside from the height close to the reference width W2v.

As illustrated in FIG. 9, the light distribution characteristics of a first lens 11 a portion of which on the vertex side of the reference width W1v is exposed to the outside and the light distribution characteristics of a second lens 12 a portion of which on the vertex side of the reference width W2v is exposed to the outside approximate each other because the first lens 11 and the second lens 12 have similar lens shapes.

Hence, in the microlens array 1F of Embodiment 6, many of the multiple second lenses 12 have light distribution characteristics that approximate the light distribution characteristics of the first lens 11. Thus the microlens array 1F of Embodiment 6 provides favorable light distribution characteristics.

(Embodiment 7)

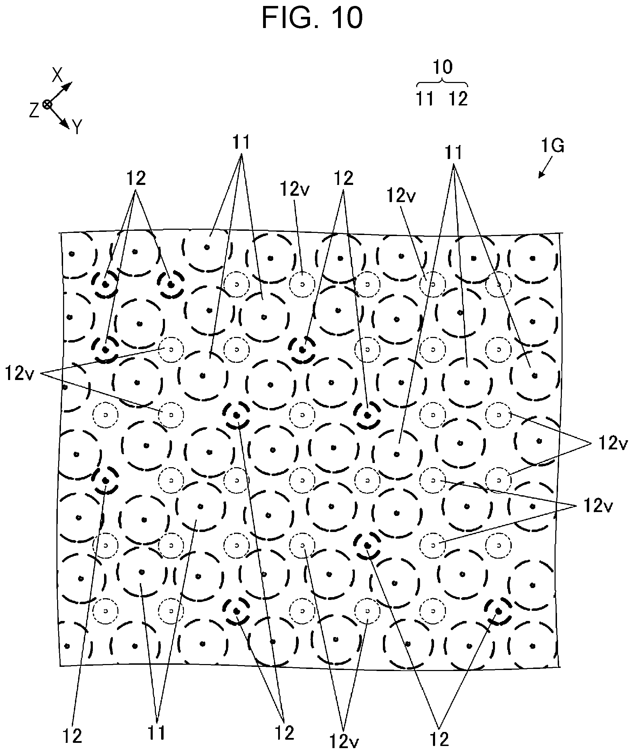

FIG. 10 is a diagram for explaining a lens arrangement in the directions parallel to the plane of a microlens array of Embodiment 7. In FIG. 10, the first lenses 11 are indicated by dashed line circles, and the second lenses 12 are indicated by bold dashed line circles. A dashed line circle represents the outer periphery of a first lens 11 approximately at half of its height. A bold dashed line circle represents the outer periphery of a second lens 12 approximately at half of its height. If the outer periphery of a second lens 12 indicated by a bold dashed line circle overlaps first lenses 11, it may not be exposed to the outside in some cases. In FIG. 10, dashed double-dotted line circles indicate imaginary lens surfaces that do not appear as lens surfaces and are referred to as imaginary second lenses 12v. The center point of each circle indicates the vertex of a lens.

In the microlens array 1G of Embodiment 7, the multiple first lenses 11 may be located in an irregular manner in plan view, and in contrast, the multiple second lenses 12 may be located in a regular manner in plan view.

The words "being located in a regular manner" denote a state in which a grid can be determined such that each one of the multiple second lenses 12 is located in a different cell of the grid. In the example of FIG. 10, a grid in which each grid cell surrounds one of the multiple second lenses 12 or the imaginary multiple second lenses 12v can be determined. The grid cells of this grid may have the same size as those of the grid for the multiple first lenses 11 rearranged such that their vertices are located in a regular manner without changing the average value of vertex densities.

This configuration provides an advantage that the arrangement of the second lenses 12 can be easily designed when the microlens array 1G is designed. Specifically, the designer first determines the locations of the multiple first lenses 11 and the multiple second lenses 12 such that the first lenses 11 and the second lenses 12 are arranged in a regular manner. After that, the vertex positions of the multiple first lenses 11 are shifted from the regular arrangement so as to be arranged in an irregular manner. Thus, the microlens array 1G of Embodiment 7 can be designed such that a second lens 12 does not appear in a valley between two adjacent first lenses 11 that is higher than the second lens 12, and a second lens 12 appears in a valley between two adjacent first lenses 11 that is lower than the second lens 12.

(Embodiment 8)

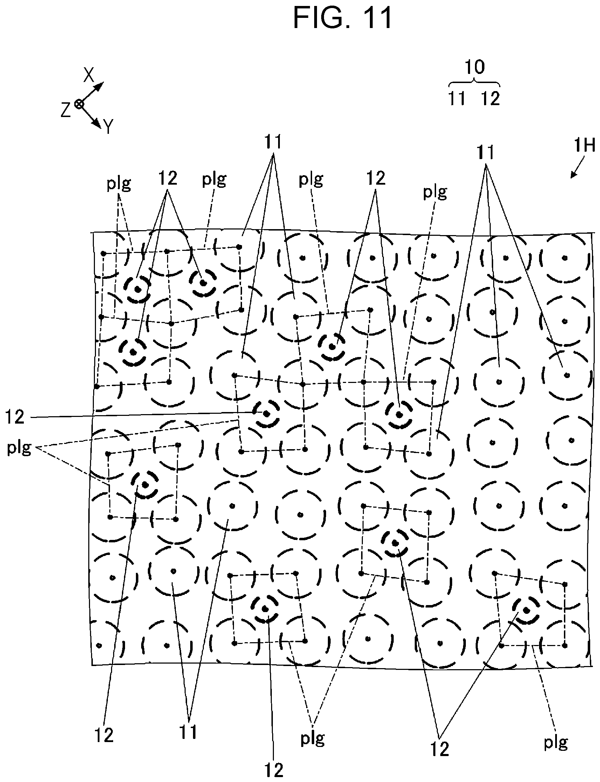

FIG. 11 is a diagram for explaining a lens arrangement in the directions parallel to the plane of a microlens array of Embodiment 8.

In the microlens array 1H of Embodiment 8, in plan view, the multiple first lenses 11 may be located in an irregular manner, and each second lens 12 may be located at the center of a polygon plg formed by connecting the vertices of the surrounding multiple first lenses 11.

The words "the first lenses 11 surrounding a second lens 12" may denote the multiple first lenses 11 that are in contact with the second lens 12 or may denote n first lenses 11 that are closest to the second lens 12.

The number n may be four if the arrangement of the multiple first lenses 11 is close to a square grid and may be six if the arrangement of the multiple first lenses 11 is close to a hexagonal grid.

The center of a polygon plg may denote the center of gravity of a polygon plg. The center of gravity denotes the position of the center of gravity if a polygon plg is assumed to be a plane having a uniform weight density, which means (the sum total of the position vectors from a reference point to all of the vertices of the polygon plg)/(the number of vertices).

Alternatively, the center of a polygon plg may be a point at which the difference in the distance from the point to each vertex of the polygon plg is smallest or may be the midpoint of the longest one of the diagonal lines of the polygon plg.

The center of a polygon plg is not limited to the points in agreement with the points defined as above in a strict sense and may be a point located within a range including an error of a tolerance or so around the point mentioned above.

This configuration increases the ratio of the number of the second lenses 12 the vertices of which appear to the number of the multiple second lenses. This reduces an imbalance of light distribution of the light having passed through the multiple second lenses 12 and enables the microlens array 1H to provide more favorable light distribution characteristics.

<Manufacturing Method>

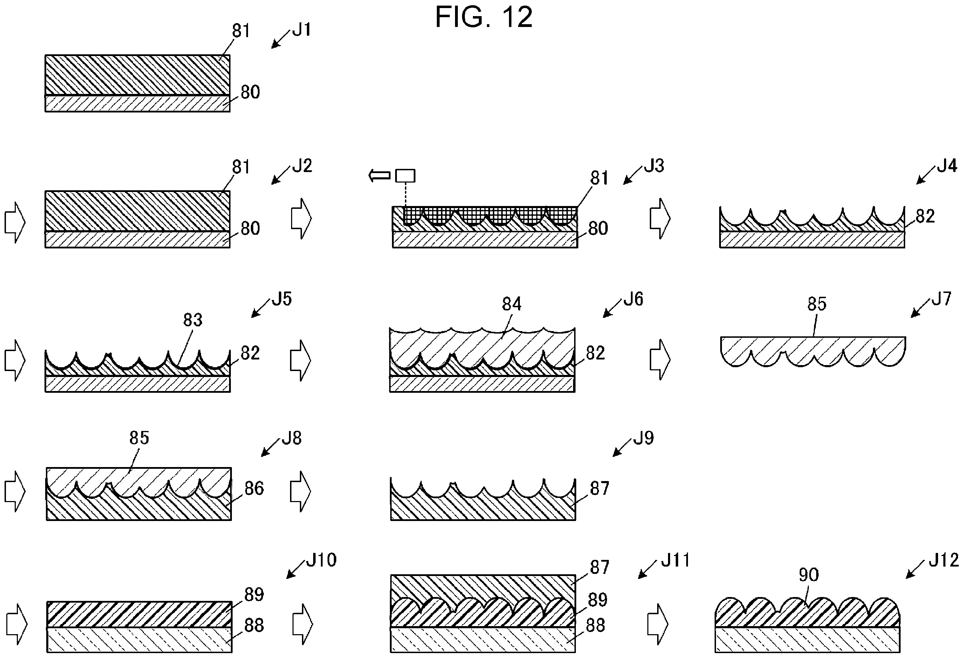

FIG. 12 is a diagram for explaining an example of a method of manufacturing a microlens array of an embodiment. The following describes manufacturing steps for the microlens array 1A of Embodiment 1. The same or similar manufacturing steps can be applied to the microlens arrays 1B to 1H of Embodiments 2 to 8.

The manufacturing steps for the microlens array 1A include master-pattern production steps (J1 to J4) for producing a master pattern, electroforming-mold production steps (J5 to J7) for producing an electroforming mold, secondary-mold production steps (J8 and J9) for producing a secondary mold, and imprint steps (J10 to J12) for molding a resin on a glass substrate.

In the master-pattern production steps, a resist resin 81 is applied to a transfer substrate 80 (step J1), and a pretreatment (for example, baking or the like) is performed on it (step J2). After that, gray-scale exposure is performed on the resist resin 81 by laser lithography (step J3). Then, after the exposure, a development treatment is performed (step J4) so that a master pattern 82 is produced. The cavities of the master pattern 82 have the shapes of the lens portions of the microlens array 1A. In the step J3 in which the portions of the resist resin 81 to be removed are exposed to light, the depth of the resist resin 81 that can be exposed to light has a limit value (for example, 15 $\mu$m to 50 $\mu$m). Hence, if a valley between first lenses 11 has a depth deeper than or equal to the limit value, the depth of the portion corresponding to the vertex of the first lens 11 in the resist resin 81 is deeper than or equal to the limit value. This makes it difficult to expose the portions of the resist resin 81 corresponding to the vertices portion of the first lenses 11 to light. However, since the microlens array 1A includes second lenses 12, there are no or less valleys the depths of which exceed the limit, which makes it easy to produce the master pattern 82 having required shapes.

In the electroforming-mold production steps, a conductive film 83 is formed on the surface of the master pattern 82 by sputtering or the like (step J5), a conductor 84 composed of Ni (nickel) or the like on which the shape of the master pattern 82 is transferred is formed by electroplating (step J6), and the conductor 84 is released and polished (step J7), so that an electroforming mold 85 is formed.

In the secondary-mold production steps, thermal imprinting is performed on a thermoplastic resin film 86 by using the electroforming mold 85 (step J8), and the resin film 86 is peeled off the electroforming mold 85 (step J9), so that a secondary mold 87 composed of a resin material is produced.

In the imprint steps, for example, a ultraviolet curing transparent resin 89 is applied to a glass substrate 88, (step J10). Then, the secondary mold 87 is brought into contact with the transparent resin 89 on the glass substrate 88, and the transparent resin 89 is cured by ultraviolet irradiation or the like (step J11). The cured transparent resin 89 is released (step J12), so that an intermediate product 90 of the microlens array 1A is produced. After that, the intermediate product 90 is subjected to characteristics evaluation, cutting with a dicing machine, an outer appearance inspection, and the like, and the microlens array 1A is thus produced.

<Light-Emitting Device and Sensor Module>

FIG. 13 is a diagram illustrating a light-emitting device and a sensor module according to an embodiment of the present disclosure. The light-emitting device 50 of the present embodiment includes a light-emitting element 51 and the microlens array 1A of Embodiment 1, which is located in the path of the light emitted by the light-emitting element 51. The microlens array 1A may be replaced with any of the microlens arrays 1B to 1H of Embodiments 2 to 8. The lens surface of the microlens array 1A (specifically, the side of the vertices of the first lenses 11 and the second lenses 12) may face the light-emitting element 51. Although the light-emitting element 51 outputs laser light, the light-emitting element 51 may be configured to emit non-laser light. The light-emitting element 51 may be housed in a package 52 having a cavity structure, and the microlens array 1A may be joined to the package 52. The microlens array 1A may also serve as a lid of the package 52.

Since the light-emitting device 50 includes the microlens array 1A of the embodiment, the light-emitting device 50 can output favorable diffused light with less interference fringes. In addition, a configuration that output favorable diffused light over a wide angle is also possible.

As illustrated in FIG. 13, the sensor module 100 of the present embodiment includes the light-emitting device 50 configured to output diffused light and a light-reception device 60 configured to receive light emitted by light-emitting device 50. The light-reception device 60 may be configured to receive direct light or reflected light of light emitted by the light-emitting device 50. The sensor module 100 may have a configuration that performs any detection such as a LiDAR (light detection and ranging) or a photoelectric sensor that detects whether an object is present in the light path. The light-emitting device 50 and the light-reception device 60 may be mounted on one module substrate 70 or separate module substrates.

The light-reception device 60 includes a light-reception element 61 such as a photodiode. The light-reception device 60 may include lenses 62 configured to collect incident light onto the light-reception element 61 and a filter element 63 configured to narrow the wavelengths of the incident light. The light-reception element 61 may be housed in a package 64, and the lenses 62 and the filter element 63 may be supported by the package 64.

Since the sensor module 100 of the present embodiment includes the microlens array 1A of an embodiment, the sensor module 100 can perform detection using favorable diffused light. In addition, detection using favorable diffused light over a wide angle can also be performed.

Note that the light-emitting device 50 of the present embodiment may have a configuration that outputs diffused light on a purpose other than detection.

The embodiments of the present disclosure have been described above. However, the microlens array, light-emitting device, and sensor module of the present disclosure are not limited to the embodiments described above. For example, although the microlens arrays according to the embodiments have been described with reference to the drawings in which the vertex heights, sizes, and lens shapes of the of the multiple first lenses 11 are the same in the above embodiments, the vertex heights, sizes, and lens shapes of the multiple first lenses 11 may have variations. Although microlenses including first lenses 11 and second lenses 12 as multiple lenses 10 have been described in the above embodiments, the multiple lenses 10 may include a third lens different from the first lenses 11 and the second lenses 12. In addition, details described in the embodiments may be changed as appropriate within a range not departing from the spirit of the invention.

INDUSTRIAL APPLICABILITY

The present disclosure is applicable to a microlens array, a light-emitting device, and a sensor module.

REFERENCE SIGNS

| | |
|---|---|
| 1A to 1H | microlens array |
| 10 | lens |
| 11 | first lens |
| 11v | first lens arranged in a regular manner |
| 12 | second lens |
| Lp | vertex distance |
| THp | threshold |
| R1 | first region |
| R2 | second region |
| R3 | third region |
| R4 | fourth region |
| H1 | first vertex height |
| HB1 | first boundary height |
| HB2 | second boundary height |
| $\Delta$H1v | reference vertical dimension |
| W1v, W2v | reference width |
| $\Delta$P | positional deviation |
| plg | polygon |
| 50 | light-emitting device |
| 51 | light-emitting element |
| 60 | light-reception device |
| 61 | light-reception element |
| 100 | sensor module |

**Claims**

1. A microlens array comprising:

   multiple first lenses having vertex heights higher than or equal to a first vertex height; and
   a second lens having a vertex height lower than the first vertex height, wherein
   the microlens array includes:

   a first region in which a vertex distance between two first lenses, of the multiple first lenses, aligned in a first direction is smaller than a threshold in plan view; and
   a second region in which a vertex distance between two first lenses, of the multiple first lenses, aligned in the first direction is larger than the threshold in plan view, and
   the second lens is located between the two first lenses in the second region.

2. The microlens array according to claim 1, wherein the microlens array further includes:

   a third region in which a vertex distance between two first lenses, of the multiple first lenses, aligned in a second direction different from the first direction is smaller than the threshold in plan view; and

a fourth region in which a vertex distance between two first lenses, of the multiple first lenses, aligned in the second direction is larger than the threshold in plan view, and

the second lens is located between first lenses, of the multiple first lenses, in a region where the second region overlaps the fourth region.

3. The microlens array according to claim 1 or 2, wherein

if the multiple first lenses are imaginarily arranged in a regular manner without changing an average value of vertex densities, and height of a lowest point in a boundary between a pair of adjacent first lenses, of the multiple first lenses, is referred to as a first boundary height, vertex height of the second lens is lower than or equal to the first boundary height.

4. The microlens array according to claim 3, wherein

$$HB1 - \Delta H1v \times 50\% \leq H2 \leq HB1 \text{ holds,}$$

where HB1 represents the first boundary height, $\Delta H1v$ represents vertical dimension of the first lenses if the first lenses are arranged in the regular manner, and
H2 represents vertex height of the second lens.

5. The microlens array according to claim 1 or 2, wherein

if the multiple first lenses are imaginarily arranged in a regular manner without changing an average value of vertex densities, and height of a highest point in a boundary between a pair of adjacent first lenses, of the multiple first lenses, is referred to as a second boundary height, vertex height of the second lens is lower than or equal to the second boundary height.

6. The microlens array according to claim 5, wherein

$$HB2 - \Delta H1v \times 50\% \leq H2 \leq HB2 \text{ holds,}$$

where HB2 represents the second boundary height,
$\Delta H1v$ represents vertical dimension of the first lenses if the first lenses are arranged in the regular manner, and
H2 represents vertex height of the second lens.

7. The microlens array according to any one of claims 1 to 6, wherein

lens shape of the second lens is similar to lens shapes of the first lenses, and
if the multiple first lenses are imaginarily arranged in a regular manner without changing an average value of vertex densities, a largest width of boundaries between one of the first lenses and surrounding ones of the first lenses is referred to as a reference width of the first lenses, and length of a portion, corresponding to the reference width of the first lenses, in the second lens having a shape similar to shapes of the first lenses is referred to as a reference width of the second lens,
the reference width of the second lens is twice an average value of positional deviations with a tolerance of ±30%, each positional deviation being a positional deviation of one of the multiple first lenses from a state in which the multiple first lenses are arranged in the regular manner.

8. The microlens array according to any one of claims 1 to 7, wherein
in plan view, a vertex of the second lens is located at a center of a polygon formed by connecting vertices of multiple first lenses, of the multiple first lenses, located around the second lens.

9. A light-emitting device comprising:

a light-emitting element; and
the microlens array according to any one of claims 1 to 6, located in a path of light emitted by the light-emitting element.

10. A sensor module comprising:

the light-emitting device according to claim 9; and
a light-reception device configured to receive light emitted by the light-emitting device.

# FIG. 1A

# FIG. 1B

## FIG. 2

## FIG. 3

# FIG. 4

# FIG. 5

## FIG. 6

X ⊗—Y
↓
Z

10
⌒
11 12

1D

11  12  11v  11  12  11v  11

H1

HB2

Hx

S1  2

## FIG. 7

X ⊗—Y
↓
Z

10
⌒
11 12

1E

11  12  11v  11  12  11v  11

H1

ΔH1v

HB2

HB1

j1

Hx

S1  2

# FIG. 8

# FIG. 9

# FIG. 10

# FIG. 11

# FIG. 12

EP 4 455 743 A1

# FIG. 13

## INTERNATIONAL SEARCH REPORT

| | International application No. |
| --- | --- |
| | **PCT/JP2022/047153** |

**A. CLASSIFICATION OF SUBJECT MATTER**

*G02B 3/00*(2006.01)i; *G02B 5/02*(2006.01)i; *H01L 31/0232*(2014.01)i; *H01L 31/12*(2006.01)i; *H01S 5/02253*(2021.01)i
FI: G02B3/00 A; H01L31/12 E; H01L31/02 D; H01S5/02253; G02B5/02

According to International Patent Classification (IPC) or to both national classification and IPC

**B. FIELDS SEARCHED**

Minimum documentation searched (classification system followed by classification symbols)
G02B3/00; G02B5/02; H01L31/0232; H01L31/12; H01S5/02253

Documentation searched other than minimum documentation to the extent that such documents are included in the fields searched
Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | US 2020/0220324 A1 (LG INNOTEK CO., LTD.) 09 July 2020 (2020-07-09) paragraphs [0001], [0002]-[0011], [0137]-[0154], [0221]-[0224], fig. 4-13, 22 | 1, 2, 8-10 |
| Y | paragraphs [0001], [0002]-[0011], [0137]-[0154], [0221]-[0224], fig. 4-13, 22 | 1-10 |
| X | WO 2021/235162 A1 (SONY SEMICONDUCTOR SOLUTIONS CORP.) 25 November 2021 (2021-11-25) claim 20, paragraphs [0001], [0002]-[0005], [0127], fig. 20F | 1, 2, 8-10 |
| Y | claim 20, paragraphs [0001], [0002]-[0005], [0127], fig. 20F | 1-10 |
| X | JP 2000-89007 A (KEIWA INC.) 31 March 2000 (2000-03-31) paragraphs [0001], [0014]-[0042], fig. 1-3 | 1, 3-6, 7, 9 |
| Y | paragraphs [0001], [0014]-[0042], fig. 1-3 | 1-10 |
| X | CN 104570172 A (TAIHU JINZHANG TECHNOLOGY CO., LTD.) 29 April 2015 (2015-04-29) paragraphs [0001]-[0040], fig. 1-4 | 1, 3-6, 7, 9 |
| Y | paragraphs [0001]-[0040], fig. 1-4 | 1-10 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **28 February 2023** | **07 March 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/047153**

| Patent document cited in search report | | | Publication date (day/month/year) | Patent family member(s) | | | Publication date (day/month/year) |
|---|---|---|---|---|---|---|---|
| US | 2020/0220324 | A1 | 09 July 2020 | WO | 2019/035653 | A1 | |
| | | | | KR | 10-2019-0019594 | A | |
| WO | 2021/235162 | A1 | 25 November 2021 | (Family: none) | | | |
| JP | 2000-89007 | A | 31 March 2000 | US | 6852396 | B1 | |
| | | | | column 1, TECHNICAL FIELD, column 3, line 1 to column 7, last line, fig. 1-3 | | | |
| | | | | WO | 2000/017676 | A1 | |
| | | | | TW | 508455 | B | |
| | | | | KR | 10-2001-0072479 | A | |
| CN | 104570172 | A | 29 April 2015 | (Family: none) | | | |

Form PCT/ISA/210 (patent family annex) (January 2015)

**EP 4 455 743 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003004907 A